Europäisches Patentamt

European Patent Office

Office européen des brevets

(11) Publication number: **0 460 356 A2**

# EUROPEAN PATENT APPLICATION

(21) Application number: **91102860.3**

(22) Date of filing: **27.02.91**

(51) Int. Cl.5: **H01L 29/40**

(30) Priority: **06.06.90 US 534078**

(43) Date of publication of application:
**11.12.91 Bulletin 91/50**

(84) Designated Contracting States:
**DE FR GB**

(71) Applicant: **International Business Machines Corporation**
**Old Orchard Road**
**Armonk, N.Y. 10504(US)**

(72) Inventor: **Jackson, Thomas Nelson**
**80 Cortlandt Avenue**
**Peekskill, New York 10566(US)**
Inventor: **Kleinsasser, Alan Willis**
**68 Starview Avenue**
**Putnam Valley, New York 10579(US)**

(74) Representative: **Jost, Ottokarl, Dipl.-Ing.**
**IBM Deutschland GmbH Patentwesen und**
**Urheberrecht Schönaicher Strasse 220**
**W-7030 Böblingen(DE)**

(54) **Contacts to semiconductors having zero resistance.**

(57) A Field Effect Transistor (FET) (10) includes a source electrode (24), a drain electrode (26) and a gate electrode (20) electrically coupled to a body (12) of semiconductor material. At least the drain electrode (26) and the source electrode (24) are each comprised of a material having superconducting properties below a predetermined temperature. The source electrode (24) and the drain electrode (26) are each disposed relative to the body of semi-conductor material (12) for inducing, via the proximity effect, a superconducting state into adjacent material (24a,26a) of the body of semiconductor material (12). As a result a parasitic electrical resistance associated with the source electrode (24) and the drain electrode (26) is substantially or entirely eliminated. The source (24) and drain (26) electrodes may be comprised of low temperature or of high temperature superconducting material.

FIG.1

## FIELD OF THE INVENTION:

This invention relates generally to semiconductor devices such as Field Effect Transistors (FETs) and, in particular, to semiconductor devices having contact electrodes comprised of superconducting material that, through the proximity effect, substantially reduces or eliminates parasitic resistance of the contact electrodes.

## BACKGROUND OF THE INVENTION:

Improved electronic circuit performance is achieved if circuit power consumption is reduced. This is especially true for highly integrated electronic circuits such as Very Large Scale Integrated (VLSI) circuits. Thus, a major design goal is the scaling down of circuit operating voltage to achieve a reduction in power consumption. In FET circuits, a parasitic series resistance due to resistances associated with FET source and drain electrodes is a significant impediment to scaling down voltage.

Superconducting FETs have been proposed by T.D. Clark et al., J. Appl. Phys. 51, 2736(1980) and by A.H. Silver et al. in "Future Trends in Superconductive Electronics", B.S. Deaver et al. Eds., American Institute of Physics, New York, 1978, page 364. The fabrication of superconducting FETs has also been reported in the literature by H. Takayanagi and T. Kawakami, Phys. Rev. Lett. 54, 2449 (1985); H. Takayanagi and T. Kawakami, Int'l. Electron Dev. Mtg. Digest, IEEE Inc., Piscataway, N.J., 1985, page 98; T. Nishino, M. Miyake, Y. Harada, and U. Kawabe, IEEE Electron Dev. Lett. EDL-6, 297 (1985); and by T. Nishino, E. Yamada, and U. Kawabe, Phys. Rev. B33, 2042 (1986). Superconducting FETs have also been reported by Z. Ivanov and T. Claeson, Jpn. J. Appl. Phys. 26, Suppl. 26-3, 1617 (1987) and by T. Nishino et al., IEEE Electron Dev. Lett. EDL-10, 61 (1989).

In a journal article entitled "Superconducting InGaAs junction field-effect transistors with Nb electrodes", Appl. Phys. Lett 55, 1909 (1989) A.W. Kleinsasser, T.N. Jackson, D. McInturff, F. Rammo, G.D. Pettit and J.M. Woodall describe a superconducting JFET having Nb source and drain electrodes.

In general these devices are intended to have a superconducting channel region. That is, the FET channel is required to be sufficiently short so that the superconducting properties of the source and drain regions overlap. The usefulness of such devices is discussed in a journal article entitled "Prospects For Proximity Effect Superconducting FETs", IEEE Trans. Magnetics MAG-25, 1274 (1989) by A.W. Kleinsasser and T.N. Jackson. A thorough discussion of the properties of these devices is found in "Modern Superconducting Devices", Academic Press, Boston, 1990 authored by A.W. Kleinsasser and W.J. Gallagher. However, such devices are relatively difficult to fabricate and also lack voltage gain.

It is thus an object of the invention to provide an electronic device in which contact electrode resistance is reduced substantially to zero.

It is another object of the invention to provide a FET in which source and drain contact resistance is reduced substantially to zero.

It is a further object of the invention to provide a FET suitable for use at reduced voltage levels by substantially eliminating the parasitic series resistance due to resistances associated with FET source and drain electrode contacts.

It is a still further object of the invention to provide an electronic device having electrodes comprised of superconducting material, the superconducting material inducing, by means of the proximity effect when operated below a critical temperature $(T_c)$, a substantially zero contact resistance in adjacent semiconductor material.

## SUMMARY OF THE INVENTION

The foregoing problems are overcome and the objects of the invention are realized by an electronic device in which contact electrode resistance is reduced substantially to zero. For example, a FET device includes a source electrode, a drain electrode and a gate electrode electrically coupled to a body of semiconductor material. In accordance with the invention at least the drain electrode and the source electrode are each comprised of a material having superconducting properties below a critical temperature. The source electrode and the drain electrode are each disposed relative to the body of semiconductor material for inducing, via the proximity effect, a superconducting state into adjacent material of the body of semiconductor material. As a result the parasitic electrical resistance associated with the source electrode and the drain electrode is substantially or entirely eliminated. The source and drain electrodes may be comprised of a low temperature or of a high temperature superconducting material.

Thus, the invention provides a FET device in which device resistance is due substantially only to channel resistance. The FET of the invention resembles in some aspects a conventional FET in that the channel is not required to be superconducting. As a result, there is no channel length restriction. A voltage potential applied to the gate electrode controls channel resistance as in a conventional FET, but parasitic resistance is eliminated. Thus, operating voltages are reduced over those required by a conventional FET with a corresponding decrease in operating power consumption. This teaching also applies to FET devices in which superconductivity is induced in the channel.

In another embodiment of the invention a bipolar transistor device includes an emitter electrode, a collector electrode and a base electrode electrically coupled to a body of semiconductor material. The electrodes are each comprised of a material having superconducting properties below a critical temperature. The electrodes are each disposed relative to the body of semiconductor material for inducing, via the proximity effect, a superconducting state into adjacent material of the body of semiconductor material for substantially eliminating parasitic electrical resistance associated with the electrodes.

In a further embodiment of the invention a photodetector has contact electrodes comprised of a low temperature or of a high temperature superconducting material for inducing, via the proximity effect, a superconducting state into adjacent material of the photodetector for substantially eliminating parasitic electrical resistance associated with the contact electrodes.

Restating the foregoing the invention pertains to an active or a passive electronic device that includes at least one contact electrode electrically coupled to a body. The device is characterized in that the at least one contact electrode is comprised of a substance having superconducting properties below a critical temperature such that when the device is operated below the critical temperature there is induced, via a proximity effect, a superconducting state into an adjacent region of the body. The induced superconducting state substantially eliminates electrical resistance associated with the contact electrode.

## BRIEF DESCRIPTION OF THE DRAWING

The above set forth and other features of the invention are made more apparent in the ensuing Detailed Description of the Invention when read in conjunction with the attached Drawing, wherein:

Fig. 1 is a cross-sectional view, not to scale, of one embodiment of a FET device constructed in accordance with the invention;

Fig. 2 is a cross-sectional view, not to scale, of one embodiment of a radiation detector device constructed in accordance with the invention; and

Fig. 3 is a cross-sectional view, not to scale, of one embodiment of a bipolar transistor device constructed in accordance with the invention.

## DETAILED DESCRIPTION OF THE INVENTION

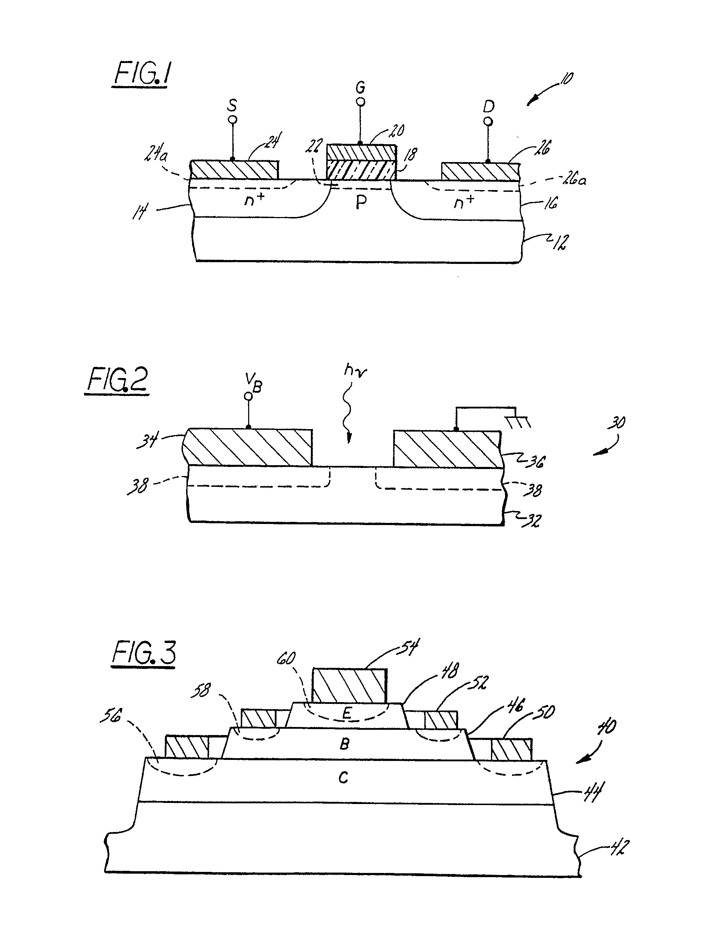

Fig. 1 is a cross-sectional view, not to scale, of one embodiment of an n-channel FET device 10 constructed in accordance with the invention. It should be noted that the FET 10 is typically part of an integrated circuit device comprised of Si, Ge, $Si_xGe_{(1-x)}$ (where $x = 0 \leq x \leq 1$), a Group III-V material such as GaAs or AlGaAs, hybrid Si/GaAs material or any suitable semiconductor material. It should also be noted that although the description is made in the context of an n-channel device that p-channel devices are also within the teaching of the invention.

FET 10 is fabricated on an p-type semiconductor body or substrate 12 and includes a source $n^+$ region 14 and a drain $n^+$ region 16. The $n^+$ regions 14 and 16 may be formed by a diffusion process, an ion implantation process or by any suitable process employing any suitable dopant species. By example, the substrate 12 is comprised p-type silicon doped with boron at a concentration of approximately $10^{16}$ $cm^{-3}$ and the $n^+$ regions 14 and 16 are ion implanted with arsenic or phosphorus at a dose of approximately $10^{15}$ $cm^{-2}$ and an energy of approximately 60 keV. FET 10 further includes an electrical insulator 18 comprised of, by example, $SiO_2$, upon which a gate conductor or metalization 20 is applied. When suitably biased a channel 22 is formed in a known manner beneath the insulator 18.

In accordance with the invention the FET 10 further includes a source electrode 24 and a drain electrode 26, both of which are comprised of material capable of exhibiting superconducting properties below a critical temperature. Schottky barriers are formed between the superconducting source and drain electrodes 24 and 26 and the source and drain $n^+$ regions 14 and 16. Due to the relatively heavy doping of the source and drain regions these barriers are relatively transparent. The thinness of the Schottky barriers facilitates, due to the proximity effect, a penetration of superconductivity into the semiconductor material of the $n^+$ regions 14 and 16 over a distance of order 100 nm. These regions of proximity effect induced superconductivity are illustrated as the regions 24a and 26a. Thus, depending upon the spacing of source electrode 24 or drain electrode 26 and the gate electrode 20 portions of the source and drain $n^+$ regions 14 and 16, and possibly part of the channel 22, exhibit superconducting properties due to the proximity effect. As a result, when cooled beneath the critical temperature of the source and drain electrode material the only significant electrical resistance of the FET 10 is that of the channel region itself.

In general the extent of the proximity region is a function of the coherence length of the semiconductor material upon which the electrode is formed.

By example, the aforedescribed journal article entitled "Prospects For Proximity Effect Superconducting FETs", IEEE Trans. Magnetics MAG-25, 1274 (1989) by A.W. Kleinsasser and T.N. Jackson illustrates in Fig. 3 the dependence of normal coherence length on temperature for n-Si and n-InAs.

The use of materials, such as InAs, which do not form Schottky barriers to the electrodes further improves coupling of superconductivity into the semiconductor material.

Materials suitable for the fabrication of the source and drain electrodes include conventional "low temperature" superconductors such as material comprised of Al, Pb and its alloys with In, Bi, Sb and Au, Nb, $NbC_xN_y$, where
$(x + y = 1)$ A-15 compounds ($Nb_3A$ with A = Al, Si, Ge, Sn, $V_3Si$ or Tungsten silicide ($WSi_x$), where $x$ = approximately $0.33 \leq x \leq 1.0$) or combinations thereof. Other materials suitable for the fabrication of the source and drain electrodes include high temperature superconductors including compounds based on compositions including (Nd, Ce, Cu, O), (Y, Ba, Cu, O), (Bi, Sr, Ca, Cu, O), (Tl, Ba, Ca, Cu, O) and elemental replacements or substitutions thereof. Examples of suitable compounds include $YBa_2Cu_3O_7$ and $Tl_2Ca_2Ba_2Cu_3O_{10}$.

For the high temperature superconducting materials listed above it may be desirable to first provide an electrically conductive buffer layer upon the semiconductor surface. By example, silver is one electrically conductive material known to be highly compatible with many high temperature superconductors.

The low temperature superconducting materials may be applied by conventional metal deposition techniques such as evaporation, Chemical Vapor Deposition (CVD) or sputtering. The high temperature superconducting materials can be applied as a uniform layer and selectively removed by laser ablation or ion milling. Alternatively, techniques such as evaporation, magnetron sputtering, CVD or Molecular Beam Epitaxy (MBE) can be employed to deposit the source and drain electrodes, with a lift-off mask used for patterning. A suitable thickness for the superconducting electrodes when comprised of high temperature superconducting material is approximately 2000 Angstroms. The gate conductor need not exhibit superconducting properties at typical operating temperatures and may be comprised of a normal metal or of a superconducting material having a critical temperature the same as or different than that of the source and drain electrodes. At least one and typically a large number of FETs constructed in accordance with the invention are provided upon an integrated circuit device. The integrated circuit device is subsequently packaged and operated at cryogenic temperatures. By example, when using certain known high temperature superconducting materials it may be desirable to operate the integrated circuit device at the temperature of liquid nitrogen.

The invention provides a FET device in which device resistance is due substantially only to channel resistance. The FET of the invention resembles in some aspects a conventional FET in that the channel is not required to be superconducting. As a result, there are no channel length restrictions as there are with the superconducting FETs described in the literature set forth above. The voltage potential applied to the gate electrode controls channel resistance as in a conventional FET, but parasitic resistance is eliminated. Thus, operating voltages can be reduced over those required by a conventional FET with a corresponding decrease in operating power consumption.

Fig. 2 illustrates in cross-section another embodiment of the invention wherein a photodetector 30 includes a radiation absorbing substrate 32 and contact electrodes 34 and 36 comprised of a low temperature or of a high temperature superconducting material. By example, substrate 32 may be comprised of a Group III-V material such as InGaAs while the electrodes may comprise any of the high temperature or low temperature superconducting materials set forth above. Electrodes 34 and 36 induce, via the proximity effect, a superconducting state into the adjacent material of the photodetector forming superconducting regions 38. The superconducting material substantially eliminates, when operated below the critical temperature of the electrode material, parasitic electrical resistance associated with the contact electrodes 34 and 36.

Fig. 3 illustrates a further embodiment of the invention wherein a p-n-p or n-p-n bipolar transistor device 40 includes a substrate 42, a collector 44, a base 46 and an emitter 48. The transistor further includes an annular collector electrode 50, an annular base electrode 52 and an emitter electrode 54 electrically coupled to the associated region of semiconductor material. By example the semiconductor material is comprised of silicon doped to provide the required electrical characteristics. The electrodes are each comprised of a material having superconducting properties below a critical temperature such as any of the materials listed above. The electrodes 50, 52 and 54 are each disposed relative to the semiconductor material for inducing, via the proximity effect, a superconducting region 56, 58 and 60, respectively, into the adjacent semiconductor material. As a result, when operated below the critical temperature parasitic electrical resistance associated with the electrodes is substantially reduced or eliminated.

The geometry and materials of the devices shown in Figs. 1, 2 and 3 are exemplary and are not intended to limit the practice of the invention to only such geometries and materials. Furthermore, the teaching of the invention is applicable to other active electronic devices including but not limited to diodes, enhancement and depletion mode MESFETs, MOSFETs, JFETS and SISFETs, and also to bipolar and unipolar transistors. The teaching of the invention is also applicable to passive electronic devices including but not limited to resistors and capacitors.

## Claims

1. An electronic device including at least one contact electrode means (24, 26, 34, 36, 50, 52, 54) electrically coupled to a body, characterized in that the at least one contact electrode means (24, 26, 34, 36, 50, 52, 54) is comprised of a material having superconducting properties below a critical temperature for inducing a superconducting state into an adjacent region (24a, 26a, 38, 56, 58, 60) of the body such that an electrical resistance associated with the contact electrode means (24, 26, 34, 36, 50, 52, 54) is substantially eliminated.

2. An electronic device as set forth in claim 1 wherein the material having superconducting properties includes a low critical temperature superconducting material selected from the group consisting essentially of Al, Pb, In, Bi, Sb and Au, Nb, $NbC_xN_y$, where $(x + y = 1)$ A-15 compounds ($Nb_3A$ with A = Al, Si, Ge, Sn, $V_3Si$ or $WSi_x$) or combinations thereof.

3. An electronic device as set forth in claim 1 wherein the material having superconducting properties includes a high critical temperature superconducting material comprised of a compound based on compositions containing (Nd, Ce, Cu, O), (Y, Ba, Cu, O), (Bi, Sr, Ca, Cu, O), or (Tl, Ba, Ca, Cu, O) and elemental replacements or substitutions thereof.

4. An electronic device as set forth in claim 1 wherein the body is comprised of material selected from the group consisting essentially of Si, Ge, Si-Ge, Group III-V material or combinations thereof.

5. An electronic device as set forth in claim 1 and further comprising an electrically conductive buffer layer interposed between the body and the at least one contact electrode means (24, 26, 34, 36, 50, 52, 54).

6. An electronic device as set forth in claim 5 wherein the electrically conductive buffer layer is comprised of silver.

7. An electronic device as set forth in claim 1 wherein the electronic device functions as a device selected from the group consisting essentially of active and passive electronic devices including diodes, enhancement or depletion mode FETs, MESFETs, MOSFETs, JFETs or SISFETs, bipolar or unipolar transistors, photodetectors, resistors, capacitors and combinations and variations thereof.

8. A transistor comprised of a body of semiconductor material having coupled thereto at least first electrode means (24), second electrode means (26) and third electrode means (20), the third electrode means (20) for controlling a current flow between the first electrode means (24) and the second electrode means (26), characterized in that at least the first electrode means (24) and the second electrode means (26) are each comprised of a material having superconducting properties below a critical temperature, wherein the first electrode means (24) and the second electrode means (26) are each disposed relative to the body of semiconductor material for inducing, via a proximity effect, a superconducting state into adjacent material (24a, 26a) of the body of semiconductor material such that an electrical resistance associated with the first electrode means (24) and the second electrode means (26) is substantially eliminated.

9. A transistor as set forth in claim 8 wherein the first electrode means (24) and the second electrode means (26) are each comprised of a material selected from a group consisting of low critical temperature superconductive material and high critical temperature superconductive material.

10. A transistor as set forth in claim 9 wherein the material is selected from the group consisting essentially of Al, Pb, In, Bi, Sb and Au, Nb, $NbC_xN_y$, where $(x + y = 1)$ A-15 compounds ($Nb_3A$ with A = Al, Si, Ge, Sn, $V_3Si$ or $WSi_x$) or combinations thereof.

11. A transistor as set forth in claim 9 wherein the material is comprised of a compound selected from the group consisting essentially of (Nd, Ce, Cu, O), (Y, Ba, Cu, O), (Bi, Sr, Ca, Cu, O), (Tl, Ba, Ca, Cu, O) and elemental replacements or substitutions thereof.

12. A transistor as set forth in claim 8 wherein the semiconductor material is selected from the group consisting essentially of Si, Ge, Si-Ge, Group III-V material or combinations thereof.

13. A transistor as set forth in claim 8 and further comprising a first doped semiconductor region (14) underlying the first electrode means (24) and a second doped semiconductor region (16) underlying the second electrode means (26), the first (14) and second (16) doped regions having a greater electrical conductivity than the surrounding semiconductor material (12) of the body.

14. An integrated circuit device including semiconductor material and a plurality of electronic devices formed upon or within the semiconductor material, the electronic devices including at least one active electronic device comprising a portion of the semiconductor material having coupled thereto at least first electrode means, second electrode means and third electrode means, the third electrode means for controlling a current flow between the first electrode means and the second electrode means, characterized in that at least the first electrode means and the second electrode means are each comprised of a material having superconducting properties below a critical temperature, wherein the first electrode means and the second electrode means are each disposed relative to the semiconductor material for inducing, via a proximity effect, a superconducting state into adjacent semiconductor material such that an electrical resistance associated with the first electrode means and the second electrode means is substantially eliminated.

15. An integrated circuit device as set forth in claim 14 wherein the first electrode means and the second electrode means are each comprised of a material selected from a group consisting of low critical temperature superconductive material and high critical temperature superconductive material.

16. An integrated circuit device as set forth in claim 15 wherein the material is selected from the group consisting essentially of Al, Pb, In, Bi, Sb and Au, Nb, $NbC_xN_y$, where $(x + y = 1)$ A-15 compounds ($Nb_3A$ with A = Al, Si, Ge, Sn, $V_3Si$ or $WSi_x$) or combinations thereof.

17. An integrated circuit device as set forth in claim 15 wherein the material is comprised of a compound selected from the group consisting essentially of (Nd, Ce, Cu, O), (Y, Ba, Cu, O), (Bi, Sr, Ca, Cu, O), (Tl, Ba, Ca, Cu, O) and elemental replacements or substitutions thereof.

18. An integrated circuit device as set forth in claim 14 wherein the semiconductor material is selected from the group consisting essentially of Si, Ge, Si-Ge, Group III-V material or combinations thereof.

19. An integrated circuit device as set forth in claim 14 wherein the active electronic device functions as a transistor.

FIG.1

FIG.2

FIG.3